(19) Europäisches Patentamt
European Patent Office
Office européen des brevets

(11) **EP 3 787 141 A1**

(12) **EUROPÄISCHE PATENTANMELDUNG**

(43) Veröffentlichungstag:
03.03.2021 Patentblatt 2021/09

(21) Anmeldenummer: 20181618.8

(22) Anmeldetag: **23.06.2020**

(51) Int Cl.:
$H02J\ 3/00^{(2006.01)}$    $H02J\ 3/32^{(2006.01)}$
$H02J\ 7/00^{(2006.01)}$    $B60L\ 53/63^{(2019.01)}$
$B60L\ 58/12^{(2019.01)}$    $B60L\ 58/16^{(2019.01)}$
$B60L\ 58/18^{(2019.01)}$    $B60L\ 58/24^{(2019.01)}$
$B60L\ 55/00^{(2019.01)}$    $G01R\ 31/387^{(2019.01)}$
$G01R\ 31/392^{(2019.01)}$

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(30) Priorität: **26.08.2019 DE 102019212762**

(71) Anmelder: **Hochschule für angewandte Wissenschaften München**
**80335 München (DE)**

(72) Erfinder:
• **MÜHLBAUER, Markus**
**80469 München (DE)**
• **BOHLEN, Oliver**
**80687 München (DE)**

(74) Vertreter: **Hoefer & Partner Patentanwälte mbB**
**Pilgersheimer Straße 20**
**81543 München (DE)**

(54) **VERFAHREN ZUM BESTIMMEN EINES LEISTUNGSANTEILS, BETRIEBSVERFAHREN, STEUEREINHEIT, ENERGIESPEICHERANORDNUNG UND STROMNETZ**

(57) Die Erfindung betrifft ein Verfahren zum Bestimmen eines relativen Leistungsanteils ($P_k$; k = 1, ..., n) eines elektrischen Energiespeichers (10-k; k = 1, ..., n) einer Energiespeicheranordnung (10) einer Mehrzahl elektrischer Energiespeicher (10-k; k = 1, ..., n), insbesondere an einer extern angeforderten und/oder bereitgestellten elektrischen Leistung (p$P_{soll}$), bei welchem (i) für den und insbesondere für jeden elektrischen Energiespeicher (10-k; k = 1, ..., n) der Energiespeicheranordnung (10) eine momentan verfügbare maximale elektrische Ladeleistung und/oder eine momentan verfügbare maximale elektrische Entladeleistung und/oder an jeweils dafür charakteristische Wert, insbesondere durch Prognose, ermittelt wird bzw. werden, (i) die ermittelte momentan verfügbare maximale elektrische Ladeleistung ($P_{ch,k}$, k = 1, ..., n) und/oder Entladeleistung ($P_{dch,k}$, k = 1, ..., n) des elektrischen Energiespeichers (10-k; k = 1, ..., n) ins Verhältnis gesetzt wird zur momentan verfügbaren elektrischen Gesamtladeleistung ($P_{ch,gesamt}$) und/oder Gesamtentladeleistung ($P_{dch,k,gesamt}$) sämtlicher elektrischer Energiespeicher (10-k; k = 1, ..., n) der Energiespeicheranordnung (10) in Summe und (iii) ein jeweils ermitteltes Verhältnis als relativer elektrischer Leistungsanteil ($P_k$; k = 1, ..., n) des jeweiligen elektrischen Energiespeichers (10) und insbesondere als Steuergröße für eine Leistungsaufteilung und/oder für eine Aufteilung eines Leistungsflusses bereitgestellt und/oder ausgegeben wird bzw. werden.

Fig. 2A

EP 3 787 141 A1

**Beschreibung**

Die Erfindung betrifft ein Verfahren zum Bestimmen eines relativen Leistungsanteils eines elektrischen Energiespeichers einer Energiespeicheranordnung einer Mehrzahl elektrischer Energiespeicher, ein Betriebsverfahren für eine elektrische Energiespeicheranordnung mit einer Mehrzahl elektrischer Energiespeicher, eine Steuereinheit für eine Energiespeicheranordnung und/oder für ein Stromnetz, eine Energiespeicheranordnung mit einer Mehrzahl elektrischer Energiespeicher sowie ein Stromnetz, insbesondere ein lokales Stromnetz oder ein Microgrid.

Im Zusammenhang mit elektrischen Energieversorgungsnetzen werden unter anderem auch Energiespeicheranordnungen mit einer Mehrzahl elektrischer Energiespeicher, zum Beispiel in Form von Batterien und dergleichen, eingesetzt. Die jeweiligen elektrischen Energiespeicher können hinsichtlich ihrer Konfiguration, ihrer Kapazität, aber auch aufgrund ihres Alters und Ladungszustands im Vergleich zueinander sehr unterschiedlich ausgebildet sein. Gleichzeitig werden zeitabhängig an eine derartige Energiespeicheranordnung und an ein elektrisches Energieversorgungsnetz insgesamt ganz unterschiedliche Anforderungen gestellt. Dies betrifft ganz allgemein den Aspekt der Leistungsanforderung, sei dies eine angeforderte Leistung zur Energieversorgung einer Last oder eine angebotene Leistung aus einer Leistungsquelle, zum Beispiel aus einem Generator, zum Aufladen der einzelnen Energiespeicher.

Für eine geeignete Erfüllung einer Leistungsanforderung an eine Energiespeicheranordnung ist es häufig nicht ausreichend oder nicht sinnvoll, die Gesamtleistung gleichförmig oder proportional auf sämtliche individuelle Energiespeicher einer Energiespeicheranordnung aufzuteilen oder Modelle zu berücksichtigen, die auf ein Angleichen der Ladungszustände sämtlicher Energiespeicher abstellen, weil dabei individuelle Aspekte eines jeweiligen Energiespeichers nicht berücksichtigt werden.

Es ist Aufgabe der vorliegenden Erfindung, ein Verfahren zum Bestimmen eines relativen Leistungsanteils eines elektrischen Energiespeichers, ein Betriebsverfahren für eine elektrische Energiespeicheranordnung, eine Steuereinheit, eine Energiespeicheranordnung sowie ein Stromnetz zu schaffen, bei welchen mit besonders einfachen Mitteln und in besonders zuverlässiger Weise die Verteilung einer Gesamtleistung gegenüber einem herkömmlichen Vorgehen verbessert wird.

Die Lösung dieser Aufgabe erfolgt durch die Gegenstände der unabhängigen Patentansprüche 1, 9, 10, 11 und 12. Vorteilhafte Fortbildungen der vorliegenden Erfindung sind Gegenstand der jeweiligen abhängigen Ansprüche.

Gemäß einem ersten Aspekt der vorliegenden Erfindung wird ein Verfahren zum Bestimmen eines - insbesondere relativen - Leistungsanteils eines oder mehrerer elektrischer Energiespeicher einer Energiespeicheranordnung mit einer Mehrzahl elektrischer Energiespeicher, insbesondere an einer extern angeforderten und/oder bereitgestellten elektrischen Leistung, geschaffen.

(i) Bei dem erfindungsgemäßen Verfahren wird oder werden für den elektrischen Energiespeicher - und insbesondere für jeden elektrischen Energiespeicher der Energiespeicheranordnung - eine momentan verfügbare maximale elektrische Ladeleistung und/oder eine momentan verfügbare maximale elektrische Entladeleistung und/oder jeweils dafür charakteristische Werte ermittelt, insbesondere durch Prognose.

(ii) Die ermittelte momentan verfügbare maximale elektrische Ladeleistung und/oder Entladeleistung des elektrischen Energiespeichers wird oder werden erfindungsgemäß ins Verhältnis gesetzt zur momentan verfügbaren elektrischen Gesamtladeleistung bzw. Gesamtentladeleistung sämtlicher elektrischer Energiespeicher der Energiespeicheranordnung in Summe.

(iii) Ein jeweils ermitteltes Verhältnis oder ein dafür repräsentativer Wert wird oder werden erfindungsgemäß als - insbesondere relativer - elektrischer Leistungsanteil eines jeweiligen elektrischen Energiespeichers - insbesondere als Steuergröße - für eine Leistungsaufteilung und/oder für eine Aufteilung eines Leistungsflusses bereitgestellt und/oder ausgegeben.

Es bieten sich unterschiedliche Möglichkeiten zur Ausführung des erfindungsgemäßen Verfahrens und seiner Teilschritte an.

So ist es denkbar, dass die oder eine momentan verfügbare maximale elektrische Ladeleistung und/oder die oder eine momentan verfügbare maximale elektrische Entladeleistung eines elektrischen Energiespeichers aus einem und/oder mehreren Prognoseverfahren ermittelt werden.

Bei der Verwendung mehrerer Prognoseverfahren kann oder können der Wert einer momentan verfügbaren maximalen elektrischen Ladeleistung und/oder der Wert einer momentan verfügbaren maximalen elektrischen Entladeleistung eines elektrischen Energiespeichers über eine Minimumsbildung von Werten aus der Mehrzahl von Leistungsprognosen ermittelt werden.

Zusätzlich oder alternativ kann oder können ein Prognoseverfahren unter der Berücksichtigung von Spannungsgrenzen, ein Prognoseverfahren unter der Berücksichtigung von Stromgrenzen, ein Prognoseverfahren unter der Berücksichtigung von Ladungsmengengrenzen und/oder ein Prognoseverfahren unter Berücksichtigung von Energiegrenzen verwendet werden.

In vorteilhafter Weise kann gemäß einer bevorzugten Ausgestaltungsform des erfindungsgemäßen Verfahrens die momentan verfügbare maximale elektrische Ladeleistung eines elektrischen Energiespeichers aus einer momentan verfügbaren elektrischen Ladeenergie des elektrischen Energiespeichers ermittelt werden, insbesondere in Bezug auf eine vorbestimmte oder vorgegebene Prognosezeitspanne.

Entsprechend kann die momentan verfügbare maximale elektrische Entladeleistung eines elektrischen Energiespeichers aus einer momentan verfügbaren elektrischen Entladeenergie des elektrischen Energiespeichers ermittelt werden.

Durch diese Maßnahmen können sowohl für den Entladeprozess zur Versorgung einer Last als auch für den Ladeprozess bei Aufnahme von Leistung aus einer Leistungsquelle, zum Beispiel aus einem Generator, die individuellen Aspekte eines jeweiligen Energiespeichers in der Gesamtheit aller Energiespeicher einer Energiespeicheranordnung berücksichtigt werden.

Das erfindungsgemäße Verfahren kann insbesondere im normalen Lastbetrieb ausgeführt und/oder verwendet werden.

Besonders einfache Verhältnisse stellen sich ein, wenn die Ermittlung der maximalen Entladeleistung bzw. der maximalen Ladeleistung jeweils im Ruhezustand und/oder stromlosen Zustand des elektrischen Energiespeichers erfolgt bzw. erfolgen.

Die Bestimmung kann zusätzlich oder alternativ jeweils als eine oder auf der Grundlage einer zeitabhängigen ladungsmengenlimitierten und/oder energiegrenzenlimitierten mittleren elektrischen Ladeleistung $p_{prog,e,ch}$ bzw. Entladeleistung $p_{prog,e,dch}$ bzw. über eine vorbestimmte Prognosezeitspanne $t_{prog,e}$ erfolgen.

Ein oder mehrere Prognosezeitspannen können eine vergleichsweise kurze oder kurzfristige Prognosezeitspanne, insbesondere unter Berücksichtigung von Stromgrenzen und/oder Spannungsgrenzen, und/oder eine vergleichsweise lange oder langfristige Prognosezeitspanne sein, insbesondere unter Berücksichtigung von Ladungsmengengrenzen und/oder von Energiegrenzen.

Dies kann - insbesondere im Zusammenhang mit einer vergleichsweise langen oder langfristigen Prognosezeitspanne $t_{prog,e}$ - zum Beispiel gemäß der nachfolgenden Vorschrift (1)

$$P_{prog,e,ch}(t) = \frac{E_{prog,ch}(t)}{t_{prog,e}} \qquad (1)$$

bzw. gemäß der nachfolgenden Vorschrift (2)

$$P_{prog,e,dch}(t) = \frac{E_{prog,dch}(t)}{t_{prog,e}} \qquad (2)$$

erfolgen, wobei $E_{prog,ch}$ und $E_{prog,dch}$ eine jeweilige momentan vorliegende elektrische Ladeenergie bzw. Entladeenergie eines jeweiligen Energiespeichers bezeichnen.

Dabei kann eine jeweilige Prognosezeitspanne und insbesondere $t_{prog,e}$ (a) als freier Parameter optimiert sein oder werden, (b) zielgrößenabhängig bestimmt sein oder werden, (c) in Bezug auf Effizienz, Bereitschaft und/oder Lastszenario der Energiespeicheranordnung und/oder der einzelnen elektrischen Energiespeicher angepasst sein oder werden und/oder (d) für eine vergleichsweise kurzfristige Prognosezeitspanne zum Beispiel in einem Bereich von etwa einer bis mehreren Sekunden, zum Beispiel bis zu etwa 60 Sekunden, und für eine vergleichsweise längerfristige Prognosezeitspanne zum Beispiel im Bereich von einer oder mehreren Minuten bis zu einer oder mehreren Stunden, zum Beispiel in einem Bereich von etwa 10 Minuten bis etwa 10 Stunden liegen.

Grundsätzlich können die momentan vorliegende elektrische Ladeenergie $E_{prog,ch}$ und die momentan vorliegende elektrische Entladeenergie $E_{prog,dch}$ eines jeweiligen Energiespeichers mittels verschiedener Prognosemethoden und/oder durch messende Verfahren bestimmt werden.

Vergleichsweise einfache Verhältnisse stellen sich ein, wenn die momentan verfügbare elektrische Ladeenergie $E_{ch}$ eines elektrischen Energiespeichers gemäß der nachfolgenden Vorschrift (3)

$$E_{ch}(t) = K(T,SoH) \cdot \int_{SoC(t)}^{SoC_{max}} OCV(SoC,T,SoH)\, dSoC \qquad (3)$$

ermittelt wird.

Alternativ oder zusätzlich kann die momentan verfügbare elektrische Entladeenergie $E_{dch}$ eines elektrischen Energiespeichers gemäß der nachfolgenden Vorschrift (4)

$$E_{dch}(t) = K(T,SoH) \cdot \int_{SoC_{min}}^{SoC(t)} OCV(SoC,T,SoH) \, dSoC \qquad (4)$$

ermittelt werden.

Dabei bezeichnen $t$ die Zeit, $K$ eine Gesamtkapazität eines jeweiligen Energiespeichers in Abhängigkeit von der Temperatur $T$ und dem Alterungsgrad $SoH$ eines jeweiligen Energiespeichers, $OCV$ die Ruhespannung des jeweiligen Energiespeichers in Abhängigkeit vom Ladezustand SoC, der Temperatur $T$ und dem Alterungsgrad $SoH$, $SoC_{min}$ und $SoC_{max}$ Minimum bzw. Maximum des Ladezustands $SoC$ des Energiespeichers.

Grundsätzlich können bei einem bevorzugten Ausführungsbeispiel des erfindungsgemäßen Verfahrens für einen jeweiligen Energiespeicher die momentan verfügbare elektrische Ladeenergie $E_{ch}$ und/oder die momentan verfügbare elektrische Entladeenergie $E_{dch}$

- mittels einer Prognose,

- auf der Grundlage eines Kennfeldes und/oder

- auf der Grundlage eines Modells des Energiespeichers und insbesondere eines Batteriemodells und zusätzlich erfasster Daten, zum Beispiel Messdaten, welche für einen aktuellen Zustand des Energiespeichers charakteristisch sind,

ermittelt werden, insbesondere im Zusammenhang mit einer Temperaturabhängigkeit und/oder einer Zeitabhängigkeit der jeweiligen Gesamtkapazität $K$, des Ladezustands $SoC$, des Alterungszustands $SoH$ und/oder der Ruhespannung $OCV$ eines jeweiligen Energiespeichers.

Die erfindungsgemäße Ermittlung einer Prognose für die momentane Ladeenergie oder Entladeenergie eines Energiespeichers auf der Grundlage einer Beschränkung mittels Ladungsmengengrenzen und/oder Energiegrenzen in der oben beschriebenen Form liefert eine vergleichsweise langfristige Prognose mit einer entsprechend vergleichsweise langen Prognosezeitspanne.

Darüber hinaus sind jedoch Prognosemodelle bekannt, die auf einer Limitierung im Hinblick auf Stromgrenzen oder Spannungsgrenzen beruhen wie dies zum Beispiel im Zusammenhang mit der DE 10 2009 049 589 A1 beschrieben ist.

Es ist von besonderem Vorteil, wenn das erfindungsgemäße Vorgehen, also insbesondere eine Prognose aufgrund einer Limitierung durch Ladungsmengengrenzen und/oder Energiegrenzen in der oben genannten Form mit herkömmlich bestimmten Leistungswerten kombiniert wird.

So ist es von besonderem Vorteil, wenn gemäß einer Weiterbildung der vorliegenden Erfindung die momentan verfügbare maximale elektrische Ladeleistung $P_{prog,ch}$ eines elektrischen Energiespeichers als kleinste elektrische Ladeleistung aus einer stromgrenzenlimitierten mittleren elektrischen Ladeleistung $P_{prog,i,ch}$, einer spannungsgrenzenlimitierten mittleren elektrischen Ladeleistung $P_{prog,u,ch}$ und/oder einer oder der erfindungsgemäßen ladungsmengengrenzenlimitierten und/oder energiegrenzenlimitierten mittleren elektrischen Ladeleistung $P_{prog,e,ch}$ ermittelt wird.

Dies kann zum Beispiel auf der Grundlage der nachfolgenden Vorschrift (5)

$$\left| P_{prog,ch} \right| = min \left( \left| P_{prog,i,ch} \right|, \left| P_{prog,u,ch} \right|, \left| P_{prog,e,ch} \right| \right) \qquad (5)$$

erfolgen.

Zusätzlich oder alternativ kann in diesem Sinne in analoger Weise die entsprechende momentan verfügbare maximale elektrische Entladeleistung $P_{prog,dch}$ eines elektrischen Energiespeichers als kleinste elektrische Entladeleistung aus einer stromgrenzenlimitierten mittleren elektrischen Entladeleistung $P_{prog,i,dch}$, einer spannungsgrenzenlimitierten mittleren elektrischen Entladeleistung $P_{prog,u,dch}$ und/oder einer oder der erfindungsgemäßen ladungsmengengrenzenlimitierten und/oder energiegrenzenlimitierten mittleren elektrischen Ladeleistung $P_{prog,e,dch}$ ermittelt werden.

Dies kann in vorteilhafter Weise gemäß der nachfolgenden Vorschrift (6)

$$\left|P_{prog,dch}\right| = min\left(\left|P_{prog,i,dch}\right|,\left|P_{prog,u,dch}\right|,\left|P_{prog,e,dch}\right|\right) \tag{6}$$

erfolgen.

Obwohl eine Bezugnahme auf einen Ruhezustand, also insbesondere auf einen für den jeweiligen Energiespeicher stromlosen Zustand, bei der Bestimmung einer momentanen Entladeenergie oder Ladeenergie häufig ausreichend sind, ergibt sich ein realistisches Bild, mit gegebenenfalls entsprechenden Vorteilen, wenn die Dynamik eines jeweiligen Energiespeichers, zum Beispiel im Sinne einer Batteriedynamik, berücksichtigt wird.

Insbesondere ist es gemäß einem anderen Ausführungsbeispiel des erfindungsgemäßen Verfahrens vorgesehen, dass die momentan verfügbare elektrische Ladeenergie $E_{ch}$ und/oder die momentan verfügbare elektrische Entladeenergie $E_{dch}$ außerhalb eines Ruhezustands und/oder außerhalb eines stromlosen Zustands eines jeweiligen Energiespeichers ermittelt und/oder dynamisch korrigiert werden.

Dabei kann die dynamisch korrigierte momentan verfügbare elektrische Ladeenergie $E_{dyn,ch}$ eines elektrischen Energiespeichers gemäß der nachfolgenden Vorschrift (7)

$$E_{dyn,ch}(t) = K(T,SoH) \cdot \left( \int_{SoC(t)}^{SoC_{max}} OCV(SoC,T,SoH)\, dSoC + \int_{SoC(t)}^{SoC_{max}} \Delta U_{dyn}(SoC,T,SoH)\, dSoC \right)$$

$$\tag{7}$$

oder gemäß der weiter angepassten Vorschrift (7a)

$$E_{dyn,ch}(t) = K(T,SoH) \cdot \left( \int_{SoC(t)}^{SoC_{max,dyn}} OCV(SoC,T,SoH)\, dSoC + \int_{SoC(t)}^{SoC_{max,dyn}} \Delta U_{dyn}(SoC,T,SoH)\, dSoC \right)$$

$$\tag{7a}$$

ermittelt werden.

Alternativ oder zusätzlich kann in analoger Weise die dynamisch korrigierte momentan verfügbare elektrische Entladeenergie $E_{dyn,dch}$ eines elektrischen Energiespeichers gemäß der nachfolgenden Vorschrift (8)

$$E_{dyn,dch}(t) = K(T,SoH) \cdot \left( \int_{SoC_{min}}^{SoC(t)} OCV(SoC,T,SoH)\, dSoC + \int_{SoC_{min}}^{SoC(t)} \Delta U_{dyn}(SoC,T,SoH)\, dSoC \right)$$

$$\tag{8}$$

oder gemäß der weiter angepassten Vorschrift (8a)

$$E_{dyn,dch}(t) = K(T,SoH) \cdot \left( \int_{SoC_{min,dyn}}^{SoC(t)} OCV(SoC,T,SoH)\, dSoC + \int_{SoC_{min,dyn}}^{SoC(t)} \Delta U_{dyn}(SoC,T,SoH)\, dSoC \right)$$

$$\tag{8a}$$

ermittelt werden.

Bei diesen Zusammenhängen bezeichnen $t$ die Zeit, $K$ eine Gesamtkapazität eines jeweiligen Energiespeichers in Abhängigkeit von der Temperatur *T* und dem Alterungsgrad *SoH, OCV* die Ruhespannung des jeweiligen Energiespeichers in Abhängigkeit vom Ladezustand *SoC,* der Temperatur *T* und dem Alterungsgrad *SoH, SoC*min und *SoC*max ein Minimum bzw. ein Maximum des Ladezustands *SoC* und *SoC*min,dyn und *SoC*max,dyn das dynamisch angepasste Minimum bzw. das dynamisch angepasste Maximum des Ladezustands *SoC* eines jeweils betrachteten Energiespeichers.

Durch diese Maßnahme lassen sich aufgrund der Berücksichtigung von Überspannungen unterschiedliche Betriebssituationen der jeweiligen Energiespeicher realistischer abbilden.

Es bieten sich schließlich verschiedene Möglichkeiten der Aufteilung einer Gesamtleistung auf der Grundlage der oben beschriebenen Bewertung an die einzelnen Energiespeicher der Energiespeicheranordnung an.

Es ist jedoch besonders vorteilhaft, wenn - gemäß bevorzugter Ausgestaltungsformen des erfindungsgemäßen Verfahrens - für einen jeweiligen elektrischen Energiespeicher der Mehrzahl elektrischer Energiespeicher der Energiespeicheranordnung bei einer extern angeforderten und/oder bereitgestellten elektrischen Sollleistung *P*soll eine jeweils anteilige Teilleistung *P*$_k$ mit *k* = 1, ..., n für jeden einzelnen Energiespeicher

(i) proportional zum Anteil einer prognostizierten Teilleistung *P*prog,k des gegebenen elektrischen Energiespeichers an der gesamten prognostizierten Leistung für alle elektrischen Energiespeicher der Energiespeicheranordnung,

(ii) proportional zu einem Minimum über der gesamten prognostizierten Leistung und der Sollleistung *P*soll und/oder

(iii) gemäß der nachfolgenden Vorschrift (9)

$$P_k = min\left(\sum_{n=1}^{n_{ESS}} |P_{prog,n}|, |P_{soll}|\right) \cdot \frac{|P_{prog,k}|}{\sum_{n=1}^{n_{ESS}} |P_{prog,n}|} \qquad (9)$$

bestimmt wird.

Die Erfindung betrifft ferner ein Betriebsverfahren für eine elektrische Energiespeicheranordnung mit einer Mehrzahl elektrischer Energiespeicher, bei welchem eine extern angeforderte und/oder bereitgestellte elektrische Leistung *P*soll unter elektrischen Energiespeichern der Mehrzahl elektrischer Energiespeicher der Energiespeicheranordnung auf der Grundlage eines erfindungsgemäßen Verfahrens zum Bestimmen eines - insbesondere relativen - Leistungsanteils eines elektrischen Energiespeichers einer Energiespeicheranordnung einer Mehrzahl elektrischer Energiespeicher aufgeteilt wird.

Das erfindungsgemäße Betriebsverfahren kann insbesondere als Betriebsverfahren für ein Stromnetz oder als Teil davon ausgebildet sein und/oder ausgeführt werden, wenn dieses eine Mehrzahl von elektrischen Energiespeichern aufweist.

Ferner ist Gegenstand der vorliegenden Erfindung auch eine Steuereinheit für eine Energiespeicheranordnung und/oder für ein Stromnetz. Die vorgeschlagene Steuereinheit ist dazu eingerichtet ist und/oder weist dazu Mittel auf, ein erfindungsgemäß ausgestaltetes Verfahren zum Bestimmen eines relativen Leistungsanteils eines elektrischen Energiespeichers einer Energiespeicheranordnung einer Mehrzahl elektrischer und/oder ein erfindungsgemäßes Betriebsverfahren zu initiieren, auszuführen, zu steuern und/oder mit einem oder in einem solchen Verfahren verwendet zu werden.

Die erfindungsgemäße Steuereinheit kann als Teil einer Energiespeicheranordnung und/oder eines Stromnetzes ausgebildet sein.

Des Weiteren schafft die vorliegende Erfindung auch eine Energiespeicheranordnung mit einer Mehrzahl elektrischer Energiespeicher, welche eingerichtet ist, ein erfindungsgemäßes Verfahren zum Bestimmen eines relativen Leistungsanteils eines elektrischen Energiespeichers und/oder ein erfindungsgemäßes Betriebsverfahren zu initiieren, auszuführen, zu steuern und/oder mit einem oder in einem in einem solchen Verfahren verwendet zu werden.

Alternativ oder zusätzlich kann die vorgeschlagene Energiespeicheranordnung eine erfindungsgemäß ausgestaltete Steuereinheit oder eine Wirkverbindung zu einer derartigen Steuereinheit aufweisen.

Die Energiespeicheranordnung gemäß der vorliegenden Erfindung kann als Teil eines Stromnetzes ausgebildet sein.

Schließlich wird mit der vorliegenden Erfindung auch ein Stromnetz als solches angegeben, welches eingerichtet ist, ein erfindungsgemäßes Verfahren zum Bestimmen eines relativen Leistungsanteils eines elektrischen Energiespeichers und/oder ein erfindungsgemäßes Betriebsverfahren zu initiieren, auszuführen, zu steuern und/oder mit einem oder in einem solchen Verfahren verwendet zu werden.

Alternativ oder zusätzlich kann das vorgeschlagene Stromnetz eine erfindungsgemäß ausgestaltete Energiespeicheranordnung, eine erfindungsgemäß ausgestaltete Steuereinheit und/oder eine Wirkverbindung zu einer derartigen Energiespeicheranordnung und/oder einer Steuereinheit aufweisen.

Diese und weitere Einzelheiten, Vorteile und Merkmale der vorliegenden Erfindung ergeben sich aus nachfolgender Beschreibung von Ausführungsbeispielen anhand der Zeichnung.

Figur 1  zeigt nach Art eines schematischen Blockdiagramms eine Ausführungsform des erfindungsgemäßen Stromnetzes 1.

Figur 2A  illustriert anhand eines schematischen Blockdiagramms die Aufteilung eines Leistungsflusses in einem Ladefall bei einer Ausführungsform des erfindungsgemäßen Stromnetzes 1.

Figur 2B  beschreibt ebenfalls auf der Grundlage eines schematischen Blockdiagramms eine Ausführungsform des erfindungsgemäßen Stromnetzes 1 mit Fokus auf eine Steuereinheit.

Figur 3  illustriert anhand eines Graphen Aspekte einer Ausführungsform der erfindungsgemäßen Energieberechnung.

Figuren 4 bis 6  beschreiben anhand von Graphen Zusammenhänge im Hinblick auf eine Leistungserfüllung bei einer Ausführungsform des erfindungsgemäßen Verfahrens.

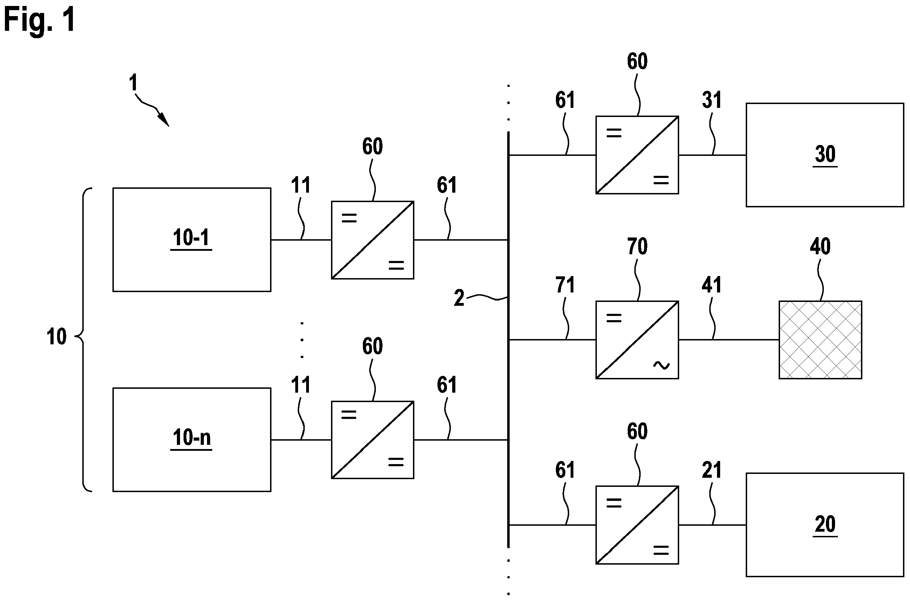

Nachfolgend werden unter Bezugnahme auf die Figuren 1 bis 6 Ausführungsbeispiele und der technische Hintergrund der Erfindung im Detail beschrieben. Gleiche und äquivalente sowie gleich oder äquivalent wirkende Elemente und Komponenten werden mit denselben Bezugszeichen bezeichnet. Nicht in jedem Fall ihres Auftretens wird die Detailbeschreibung der bezeichneten Elemente und Komponenten wiedergegeben.

Die dargestellten Merkmale und weiteren Eigenschaften können in beliebiger Form voneinander isoliert und beliebig miteinander kombiniert werden, ohne den Kern der Erfindung zu verlassen.

Die Erfindung betrifft insbesondere den technischen Bereich von Batteriespeichersystemen und/oder stationären elektrischen Energiespeichersystemen sowie Aspekte der Leistungs- und Energieverteilung in Stromnetzen und insbesondere in sogenannten Microgrids. Auch werden dabei insbesondere Aspekte der Regelungs- und Steuerungstechnik berücksichtigt. Dabei wird unter einem Microgrid ein - insbesondere dezentrales - elektrisches Stromversorgungsteilnetz mit elektrischen Energiespeichern verstanden, welches an ein übergeordnetes Stromnetz angeschlossen ist und eine angeforderte Leistung über die Energiespeicher bereitstellen bzw. eine über das Stromnetz angebotene Leistung zur Aufladung der Energiespeicher aufnehmen kann.

Vorangehend und nachfolgend kann unter einem Microgrid zum Beispiel unter anderem eine Anordnung oder Gruppe miteinander verbundener Lasten und verteilter Quellen elektrischer Energie innerhalb klar definierter elektrischer Grenzen verstanden werden, welche als einzelne oder gemeinsame steuerbare Einheit in Bezug auf ein übergeordnetes Netz fungiert. Ein Microgrid kann mit einem übergeordneten Netz verbunden oder von diesen getrennt betrieben werden.

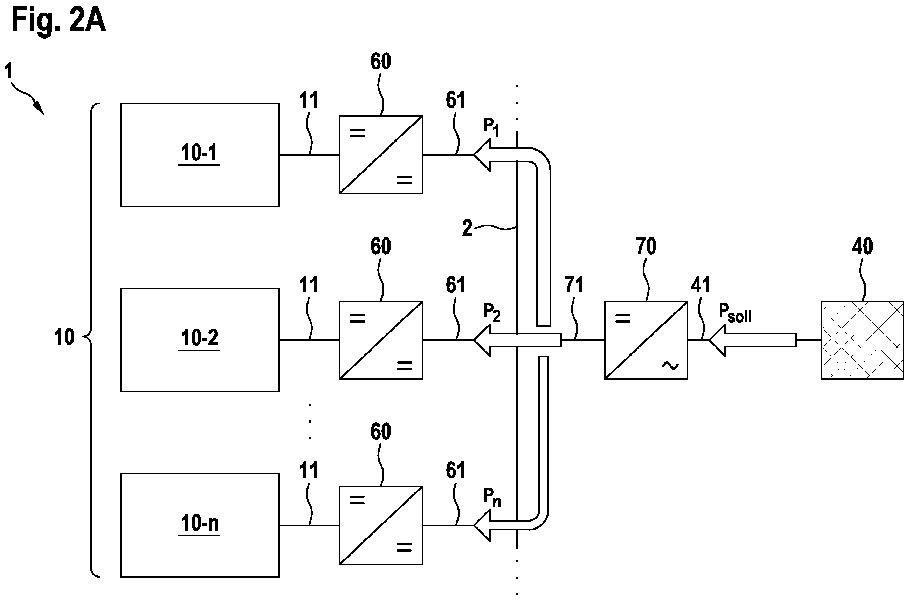

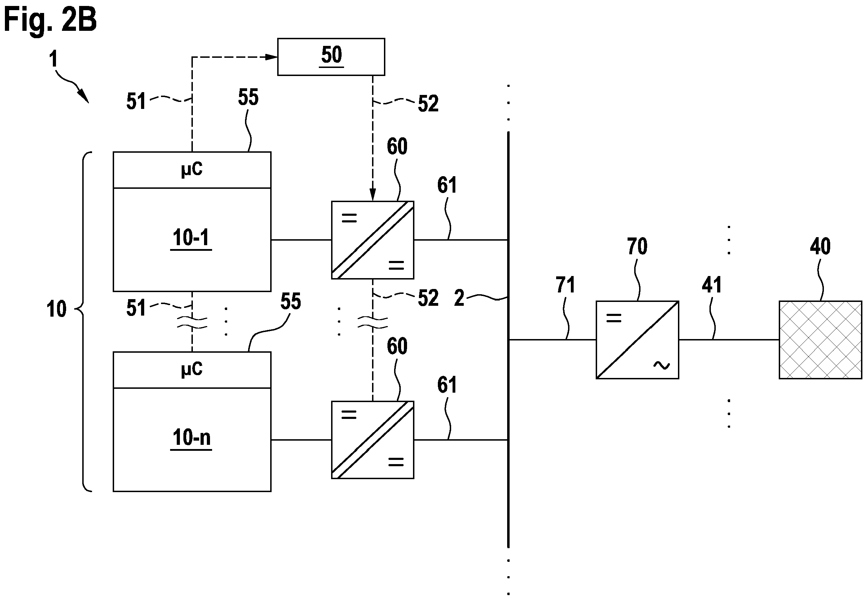

Die Figuren 1 bis 2B zeigen nach Art schematischer Blockdiagramme Ausführungsformen eines erfindungsgemäß ausgestalteten Netzes 1, zum Beispiel im Sinne eines Stromnetzes oder Microgrids, und zwar in Figur 2A mit Fokus auf die Aufteilung der Gesamtleistung $P_{soll}$, welche auch mit dem Formelzeichen $P^*$ bezeichnet werden kann, in Teilleistungen $P_k$ für die einzelnen elektrischen Energiespeicher 10-k, k = 1, ..., n einer gegebenen Energiespeicheranordnung 10 und in Figur 2B mit Fokus auf das Zusammenwirken einer Steuereinheit 50 und Mikrocontrollern 55, welche den einzelnen elektrischen Energiespeichern 10-k, k = 1, ..., n zugeordnet sind, sowie mit Gleichspannungswandlern oder DC-DC-Wandlern 60.

Das Netz 1 insgesamt wird dem Kern nach gebildet von einem Hauptstrang 2 oder einer Hauptleitung 2, von welcher über Teilleitungen 61 zu DC-DC-Wandlern einerseits die Energiespeicher 10-k, k = 1, ..., n und andererseits Leistungssenken 20, zum Beispiel in Form von Verbrauchern oder Lasten, und Leistungsquellen 30, zum Beispiel über Erzeuger oder Generatoren, abzweigen.

Über eine weitere Leitung 71 ist an den Hauptstrang 2 über einen Gleichrichter 70 das Hauptnetz 40 angeschlossen.

Dargestellt sind noch die zu den Energiespeichern 10-k, k = 1, ..., n, zu den Senken 20, zu den Quellen 30 und zum Hauptnetz 40 zuführenden Teilleitungen 11, 21, 31 bzw. 41.

In Figur 2 B sind die DC-DC-Wandler 60 über die Leitungen 51 und 52 zum Zusammenwirken mit der Steuereinheit 50 und den Mikrocontrollern 55 der Energiespeicher 10-k, k = 1, ..., n eingerichtet.

Im Rahmen der vorliegenden Erfindung betrachtete Systeme 1, zum Beispiel im Sinne von Netzen, Stromnetzen oder Microgrids, können aus mehreren Energiespeichern 10-k, k = 1, ..., n bestehen (k und n sind vorangehend und nachfolgend natürliche Zahlen), die sich zum Beispiel durch leistungselektronische Schaltungen, gegebenenfalls im Sinne einer Steuereinheit 50 mit oder aus Mikrocontrollern 55, einzeln steuern lassen und damit zu einer Gesamtleistung beitragen.

In Microgrids können grundsätzlich verschiedene Leistungsquellen 30 und Leistungssenken 20 verbunden sein. Energiespeicher 10-k, k = 1, ..., n stellen dabei eine Besonderheit dar, indem sie je nach Betriebsart - nämlich einem Entladen und oder Laden - sowohl als Quelle als auch Senke fungieren können.

Ist die vom Gesamtsystem 1 geforderte Lade- oder Entladeleistung $P_{soll}$ kleiner als die Summe der maximal möglichen Teilleistungen der Systemkomponenten, entstehen neue Freiheitsgrade bei der Aufteilung der Gesamtleistung.

Erfindungsgemäß werden Verfahren - realisiert über integrierte und/oder diskrete Schaltungen, ASICs, FPGAs, Mikrocontroller und/oder hardwaretechnisch und/oder softwaretechnisch realisierte Verfahren und Algorithmen zur Leistungsaufteilung - implementiert, um den Energiefluss im Gesamtsystem steuern.

Erfindungsgemäß ist das herkömmliche hierarchische Regelungskonzept jedoch nicht zwingend notwendig. Sämtliche mit der Erfindung vorgeschlagenen Mechanismen zur Leistungsbewertung und Leistungsaufteilung können auch unabhängig von der herkömmlichen hierarchischen Struktur des Steuerns und Regelns angewandt werden.

Die herkömmlicherweise einfachste Möglichkeit zur Leistungsaufteilung ist eine proportionale Aufteilung, so dass beispielsweise bei drei Speichern jeder ein Drittel einer geforderten Gesamtleistung trägt. Es sind auch deutlich aufwändigere Verfahren bekannt, zum Beispiel im Zusammenhang mit Kostenfunktionen für die Komponenten eines Microgrids und mit einer Leistungsaufteilung derart, dass die Summe der Kostenfunktionen der Komponenten minimal wird. Weiterhin sind auch Echtzeitoptimierungen von Energiespeichersystemen bekannt, welche eine modellprädiktive Regelung einsetzen. Ein anderer herkömmlicher Ansatz beruht darauf, die Ladezustände der einzelnen elektrischen Energiespeicher im Betrieb aneinander anzugleichen. Demnach werden Batterien mit hohem Ladezustand stärker beim Entladen und Batterien mit geringem Ladezustand stärker beim Laden belastet.

Eine allgemeine Aufgabenstellung der Erfindung besteht zum Beispiel darin, in einem Microgrid 1, wie es zum Beispiel in den Figuren 1, 2A und 2B dargestellt ist, und insbesondere in einem Verbund von Energiespeichern 10-k, k = 1, ..., n mit gekoppelten Leistungsstellern 20, 30 als Leistungssenken bzw. als Leistungsquelle die angebotene oder geforderte Gesamtleistung $P_{soll}$ so zu verteilen, dass die geforderte Gesamtleistung $P_{soll}$ bestmöglich erfüllt wird.

Vorteilhaft ist hierbei, dass erfindungsgemäß jeder Teilspeicher 10-k, k = 1, ..., n im System 1 individuell belastet werden kann, wobei erfindungsgemäß insbesondere die Entwicklung und Bereitstellung eines Verfahrens zur Bestimmung einer Leistungsaufteilung im Fokus steht.

Es ist also erfindungsgemäß ein Ziel, die individuell ansteuerbaren Energiespeicher 10-k, k = 1, ..., n optimal hinsichtlich verschiedener Zielaspekte, wie z.B. der Erfüllung einer vorgegebenen Gesamtleistung $P_{soll}$, zu belasten.

Eine derartige individuelle Leistungsaufteilung in einem Speicherverbund ist im Zusammenhang mit der Figur 2A dargestellt, und zwar nach Art einer individuellen Leistungsaufteilung für die Energiespeicher 10-k, k = 1, ..., n in einem Speicherverbund 10. Figur 1 zeigt nach Art eines schematischen Blockdiagramms eine Ausführungsform des erfindungsgemäßen Stromnetzes 1.

Die Figur 2A illustriert dazu anhand eines schematischen Blockdiagramms die Aufteilung eines Leistungsflusses für eine Gesamtleistung $P_{soll}$ in einem Ladefall bei einer Ausführungsform eines erfindungsgemäß ausgestalteten Netzes 1 in einzelne Teilleistungen $P_k$ für die einzelnen elektrischen Energiespeicher 10-k, k = 1, ..., n.

Da die einzelnen elektrischen Energiespeicher 10-k, k = 1, ..., n deutlich unterschiedliche Eigenschaften bezüglich Energieinhalt, Leistungsfähigkeit und Alterungsgrad haben können, kann bei unpassender Leistungsaufteilung kein sicherer Systembetrieb garantiert werden.

Herkömmlicherweise können in einem solchen Fall einzelne Speicher 10-k, k = 1, ..., n auch außerhalb ihres zugeordneten oder geeigneten Betriebsbereichs betrieben und im schlimmsten Fall durch Überladung bzw. Tiefentladung geschädigt werden. Eine solche Situation wird erfindungsgemäß vermieden.

Weiterhin kann eine herkömmlicherweise geforderte statische und/oder gleichmäßige Leistungsaufteilung problematisch sein, weil diese dazu führen kann, dass die Gesamtleistung $P_{soll}$ nicht mehr erfüllt werden kann. Dies ist herkömmlicherweise dann der Fall, wenn an einem Speicher die Leistung aufgrund nahezu vollständiger Ladung bzw. Entladung reduziert werden muss.

Auch dieses Problem wird erfindungsgemäß mit dem neu entwickelten Verfahren zur Leistungsaufteilung verringert oder gar vermieden.

Dadurch können erfindungsgemäß beispielsweise eine beschleunigte Alterung oder der vorzeitige Austausch der Speicherelemente vermieden werden. Folglich kann auf der Grundlage der vorliegenden Erfindung ein Gesamtoptimum hinsichtlich Wirtschaftlichkeit und Effizienz im Gesamtsystem angestrebt werden.

Gemäß Ausführungsformen der vorliegenden Erfindung werden batteriespezifische Eigenschaften wie Ladezustand, Temperatur und Alterungsgrad bei der Verteilung der Leistung im Energiespeichersystem 10 berücksichtigt, um einen intelligenten Betrieb des übergeordneten Systems 1 zu ermöglichen.

Zu diesem Zweck werden gemäß einer bevorzugten Ausgestaltungsform der vorliegenden Erfindung von allen Speichern 10-k, k = 1, ..., n der Energiespeicheranordnung 10 mindestens die momentan maximal verfügbare Lade- und Entladeleistung und die momentan maximal verfügbare Lade- und Entladeenergie als wichtige Kenngrößen bestimmt.

Der Vorgang, der die momentan maximal verfügbare Lade- und Entladeleistung bestimmt, kann auch als Leistungsprognose aufgefasst werden.

Die Leistungsprognose kann zum Beispiel durch Kennfelder geschehen, in denen die Maximalleistung abhängig von Einflussgrößen wie Ladezustand SoC und Temperatur T abgelegt ist.

Alternativ oder zusätzlich kann die Leistungsprognose auch dynamisch erfolgen, zum Beispiel anhand eines Batteriemodells.

Derartige Aspekte einer Leistungsprognose sind in der DE 10 2009 049 589 A1 beschrieben.

Weiterhin kann gemäß einem anderen Aspekt der vorliegenden Erfindung die maximal verfügbare Lade- und Entladeenergie bestimmt werden. Auch hierfür können entweder Kennfelder oder ein Batteriemodell zur Ermittlung der Kenngröße hinterlegt werden.

Diese sind wiederrum abhängig vom aktuellen Strom $I(t)$, vom Ladezustand $SoC(t)$, von der Temperatur $T(t)$ und dem aktuellen Alterungsgrad $SoH(t)$ des jeweils betrachteten elektrischen Energiespeichers 10-k, k = 1, ..., n.

Um beide Kenngrößen vergleichbar zu machen, wird bei der Energieprognose ein Prognosezeitraum $t_{prog,e}$ zu Grunde gelegt. Dadurch kann eine maximale Leistung ermittelt werden, die im festgelegten Zeithorizont die verfügbare Energiemenge berücksichtigt.

Die Bestimmung oder Berechnung einer Energieprognose kann dabei auf der Grundlage der oben bereits angegebenen Vorschriften (3) und (4) erfolgen. Das bedeutet in diesem Zusammenhang, dass mit diesen Vorschriften für einen jeweils betrachteten elektrischen Energiespeicher 10-k, k = 1, ..., n der Energiespeicheranordnung 10 gemäß den Darstellungen aus den Figuren 1 bis 2B die zum Zeitpunkt $t$ jeweils verbleibende Ladeenergie $E_{ch}$ und Entladeenergie $E_{dch}$ bestimmt wird, und zwar als Funktion der Zeit t und im Ruhezustand oder stromlosen Zustand mit $I(t) = 0$.

In diesem Zusammenhang wird noch einmal erwähnt, dass bei den Vorschriften (3) und (4) für einen jeweils betrachteten elektrischen Energiespeicher 10-k, k = 1, ..., n der Energiespeicheranordnung 10 die Größe $K$ die Gesamtkapazität in Abhängigkeit von der Temperatur $T$ und dem Alterungsgrad $SoH$ und die Größe $OCV$ die Ruhespannung in Abhängigkeit vom Ladezustand $SoC$, der Temperatur $T$ und dem Alterungsgrad $SoH$ des jeweils betrachteten Energiespeichers 10-k, k = 1, ..., n der Energiespeicheranordnung 10 bezeichnen.

Demnach wären im einfachsten Fall die prognostizierte und momentan maximal verfügbare Ladeenergie $E_{prog,ch}$ und Entladeenergie $E_{prog,dch}$ für einen jeweiligen elektrischen Energiespeicher 10-k, k = 1, ..., n der Energiespeicheranordnung 10 mit den Ausdrücken (3) und (4) gegeben zu

$$E_{prog,ch}(t) = E_{ch}(t) \qquad \text{und} \qquad E_{prog,dch}(t) = E_{dch}(t) \ . \qquad (10, 11)$$

Zur Bestimmung oder Berechnung einer Leistungsprognose für einen jeweiligen elektrischen Energiespeicher 10-k, k = 1, ..., n der Energiespeicheranordnung 10 wird auf die oben dargestellten Vorschriften (1) und (2) unter Verwendung der Ausdrücke (10) und (11) zurückgegriffen, um so für einen jeweiligen elektrischen Energiespeicher 10-k, k = 1, ..., n der Energiespeicheranordnung 10 die momentan maximal verfügbare Ladeleistung und Entladeleistung im Prognosezeitraum $t_{prog,e}$ zu ermitteln.

Diese Leistungsprognose stellt eine auf einen jeweiligen Grenzwert der Energie beschränkte Prognose dar.

Wie oben bereits beschrieben wurde, wird in diesem Zusammenhang in vorteilhafter Weise zusätzlich auf Aspekte einer stromgrenzenlimitierten und/oder einer spannungsgrenzenlimitierten mittleren elektrischen Ladeleistung $P_{prog,i,ch}$, $P_{prog,u,ch}$ und Entladeleistung $P_{prog,i,dch}$, $P_{prog,u,dch}$ zurückgegriffen, insbesondere über die Kombination in der Minimumsfunktion gemäß den oben eingeführten Ausdrücken (5) und (6).

Dabei beziehen sich - wie bereits erwähnt wurde - (A) $P_{prog,i,ch}$, $P_{prog,i,dch}$ jeweils auf eine Limitierung aufgrund einer Stromgrenze, (B) $P_{prog,u,ch}$, $P_{prog,u,dch}$ jeweils auf eine Limitierung aufgrund einer Spannungsgrenze und (C) $P_{prog,e,ch}$, $P_{prog,e,dch}$ jeweils auf eine erfindungsgemäße Limitierung aufgrund einer Ladungsmengengrenze und/oder Energiegrenze.

Die Bestimmung oder Berechnung gemäß den Aspekten (A) und (B) kann erfolgen, wie dies im Zusammenhang mit der DE 10 2009 049 589 A1 beschrieben ist.

Bei der Bestimmung oder Berechnung der Leistungsaufteilung können unter anderem grundsätzlich zwei Fälle auftreten:

(1) Die maximale Gesamtleistung der Energiespeicheranordnung 10 ist kleiner als die angeforderte oder bereitgestellte Leistung $P_{soll}$ oder $P^*$. In diesem Fall kann unabhängig von der Methode der Leistungsaufteilung nur die maximale Lade- oder Entladeleistung der einzelnen elektrischen Energiespeicher 10-k, k = 1, ..., n der Energiespeicheranordnung 10 abgerufen werden.

(2) Die maximale Leistung eines elektrischen Energiespeichers 10-k, k = 1, ..., n der Energiespeicheranordnung 10 ist geringer als der berechnete Anteil $P_k$ an der Leistung $P_{soll}$, der vom einzelnen elektrischen Energiespeicher 10-k, k = 1, ..., n bereitgestellt werden soll. Dieser Fall tritt dann ein, wenn ein Energiespeicher 10-k, k = 1, ..., n eine oder mehrere seiner Betriebsgrenzen erreicht. Dadurch würde die Gesamtleistung des Speichersystems 10 reduziert werden und Leistungsanforderungen könnten nicht erfüllt werden.

Es sind Verfahren zur Leistungsaufteilung bekannt, die einen Ausgleich der Ladezustände der Energiespeicher 10-k, k = 1, ..., n als Ziel haben und als Erweiterung der Droopmethode als "virtual power rating" bezeichnet werden.

Das "virtual power rating" liefert jedoch im Gegensatz zum erfindungsgemäßen Vorgehen keinen Prognosewert der Leistungsfähigkeit der einzelnen elektrischen Energiespeicher 10-k, k = 1, ..., n, sondern einen Wert, der definiert wird durch die maximal erlaubte Spannungsabweichung an einem DC-Bus sowie durch den jeweiligen Droopkoeffizienten.

Demnach werden herkömmlicherweise zum Erreichen eines Ladezustandsausgleichs zwei virtuelle Kennlinien für die Droopmethode eingeführt, die jeweils für einen niedrigeren oder höheren SoC die passende Leistungsvorgabe einstellen.

Im vorliegenden Fall basiert die erfindungsgemäße Bestimmung der Leistungsfähigkeit eines Energiespeicher 10-k, k = 1, ..., n hingegen auf prognostizierten Lade- und Entladeleistungen, die Strom-, Spannungs-, Ladungsmengen- und/oder Energielimits berücksichtigen.

Weiterhin stehen zwei Zeitkonstanten $t_{prog,p}$ und $t_{prog,e}$ zur Verfügung, mit denen der Prognosehorizont zur Berechnung der Leistungsfähigkeit variiert werden kann.

Durch diese Variation kann je nach Anforderung einerseits ein leistungsstarker elektrischer Energiespeicher 10-k, k = 1, ..., n stärker belastet werden oder andererseits ein langfristiger Ausgleich aller Energiespeicher 10-k, k = 1, ..., n erfolgen.

Der Zeitraum $t_{prog,p}$ für die Leistungsprognose liegt insbesondere im Bereich von Sekunden.

Der Zeitraum $t_{prog,e}$ für die Energieprognose liegt insbesondere im Bereich von Minuten oder Stunden.

Die konkrete Bestimmung der geeigneten Zeitkonstanten $t_{prog,p}$ und $t_{prog,e}$ als Prognosezeiten kann auf verschiedene Art geschehen.

Zum Beispiel ist es denkbar, dass die Prognosezeiten $t_{prog,p}$ und $t_{prog,e}$ durch systematische Variation ("gezieltes Ausprobieren") bestimmt werden.

Zusätzlich oder alternativ ist es denkbar, dass die Prognosezeiten $t_{prog,p}$ und $t_{prog,e}$ als freie Parameter des erfindungsgemäßen Verfahrens und insbesondere eines zu Grunde liegenden Algorithmus durch Optimierung bestimmt werden, die für gegebene Zielgrößen (z.B. Effizienz und Funktionserfüllung) die optimalen Parameter bestimmen.

Zur erfindungsgemäßen Leistungsaufteilung können folglich die leistungsbezogenen Kenngrößen aus der prognostizierten Leistungsfähigkeit im erfindungsgemäßen Verfahren oder einem zu Grunde liegenden Algorithmus herangezogen und Aufteilungsfaktoren proportional zur prognostizierten Gesamtleistung berechnet werden, wie dies oben im Zusammenhang mit der Vorschrift (9) erläutert wurde.

Die zu berechnende Teilleistung $P_k$ für den k-ten elektrischen Energiespeichers 10-k mit k = 1, ..., n ergibt sich im Zusammenhang mit der Auswertungsvorschrift (9) aus dem Produkt des minimalen Leistungswerts zwischen der gesamten prognostizierten Leistung - nämlich der Summe der prognostizierten maximalen Leistungen und der elektrischen Energiespeicher 10-k mit k = 1, ..., n in ihrer Gesamtheit - und der vorgegebenen Sollleistung $P_{soll}$ oder $P^*$ und dem Anteil der Teilleistung $P_{prog,k}$ des k-ten elektrischen Energiespeichers 10-k, k = 1, ..., n an der Summe der prognostizierten Teilleistungen .

Sofern die Vorschrift (9) erfindungsgemäß zur Leistungsaufteilung herangezogen wird, kann aufgrund der Berechnung der Prognosewerte und der hinterlegten Limits eine Umverteilung der Teilleistungen stattfinden.

Erreicht beispielsweise ein elektrischer Energiespeicher 10-k, k = 1, ..., n seine Grenzen, kompensieren die restlichen Energiespeicher 10-k, k = 1, ..., n die fehlende Leistung solange deren Grenzen nicht ebenfalls erreicht sind.

Folglich können - wie im Fall (2) beschrieben ist - die Reduktion der Gesamtleistung zeitlich vermieden und eine vorzeitige Nichterfüllung der Leistungsanforderungen verhindert werden.

Zur weiteren Verbesserung des prognostizierten Werts für die momentan maximal verfügbare Lade- und Entladeleistung können bei bevorzugten Ausführungsformen der vorliegenden Erfindung weitere Optimierungen getroffen werden.

Im Wesentlichen tragen dazu zwei Effekte bei, die während einer Belastung eines elektrischen Energiespeichers 10-k, k = 1, ..., n, entstehen, also im Lastfall mit $I(t) \neq 0$.

(a) Einerseits ändert sich im Lastfall mit $I(t) \neq 0$ aufgrund der dynamischen Überspannung $\Delta U_{dyn}$ des elektrischen Energiespeichers 10-k, k = 1, ..., n als Batterie für eine konstante Belastung die verbleibende Lade- oder Entladeenergie. Dementsprechend können die Vorschriften (3) und (4) zur Bestimmung der verbleibenden Lade- und Entladeenergie unter Beachtung des Vorzeichens von $\Delta U_{dyn}$ (positives Vorzeichen für Laden, negatives Vorzeichen für Entladen) zu den oben bereits beschriebenen Vorschriften (7) und (8) erweitert werden.

(b) Daraus resultiert jedoch, dass aufgrund von $\Delta U_{dyn}$ die Lade- bzw. Entladeschlussspannungen früher erreicht werden. Somit ändert sich andererseits auch in Abhängigkeit der Belastung die maximale Kapazität des elektrischen Energiespeichers 10-k, k = 1, ..., n als Batterie für eine konstante Belastung. Dies führt dazu, dass die Integrationsgrenzen in den Vorschriften (7) und (8) an den minimalen bzw. maximalen SoC, abhängig von den prognostizierten Leistungen, vorteilhafterweise weiter angepasst werden müssen. Dies wird in den Auswertevorschriften (7a) und (8a), die oben bereits diskutiert wurden, berücksichtigt.

Dabei bezeichnen $SoC_{max,dyn}$ und $SoC_{max,dyn}$ den maximalen bzw. minimalen SoC, bei dem mit kontinuierlicher Ladung oder Entladung mit dem prognostizierten Leistungswert die Spannungsgrenzen $U_{max}$ (beim Laden) bzw. $U_{min}$ (beim Entladen) erreicht werden.

Die Werte $E_{dyn,ch}(t)$ und $E_{dyn,dch}(t)$ können für die Werte $E_{prog,ch}(t)$ und $E_{prog,dch}(t)$ für die Leistungsprognose und für die Leistungsaufteilung verwendet und eingesetzt werden.

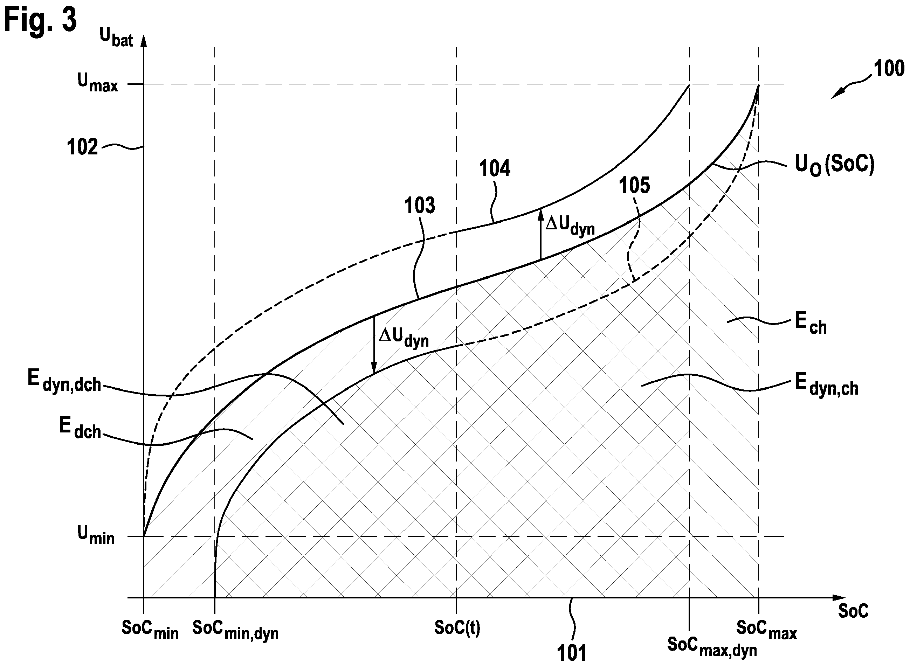

Die Energieberechnung und vor allem die verbesserte Energieberechnung sind im Zusammenhang mit Figur 3 im Detail dargestellt, welche dazu anhand eines Graphen 100 Aspekte einer Ausführungsform der erfindungsgemäßen Energieberechnung illustriert.

Im Graphen 100 der Figur 3 sind auf der Abszisse 101 der Ladungszustand SoC und auf der Ordinate 102 die Batteriespannung $U_{bat}$ - also die Spannung eines betrachteten elektrischen Energiespeichers 10-k mit k = 1, ..., n - aufgefasst als Batterie - aufgetragen.

Eine Ausführungsform der Erfindung wird anhand der Darstellung der Figur 2B im Detail erläutert, wobei insbesondere auf ein Zusammenwirken mit einer erfindungsgemäß ausgestalteten Steuereinheit 50 abgestellt wird, welche über eine erste Steuer-/Erfassungsleitung 51 einerseits mit den Energiespeichern 10-k und deren Mikrocontrollern 55 und über eine zweite Steuer-/Erfassungsleitung 52 andererseits mit Gleichspannungswandlern Gleichspannungswandler 60 oder DC-DC-Wandlern in Wirkverbindung steht

Die Erfindung kann in leistungselektronisch geführten Systemen (z.B. Microgrids) eingesetzt werden. Durch den Freiheitsgrad der freien Leistungsaufteilung gemäß der vorliegenden Erfindung und aufgrund der galvanischen Trennung der einzelnen Energiespeicher 10-k mit k = 1, ..., n kann der Leistungselektronik der Gleichspannungswandler 60 eine Leistungsvorgabe übermittelt werden.

In Abhängigkeit der speicherspezifischen Kenngrößen, z.B. einer maximal verfügbaren Lade- und Entladeleistung bzw. -energie, ermittelt das Energiemanagementsystem - zum Beispiel repräsentiert durch eine erfindungsgemäß ausgestaltete Steuereinheit 50 - auf der Basis einer Ausführungsform des erfindungsgemäßen Verfahrens zum Bestimmen eines Leistungsanteils eines elektrischen Energiespeichers 10-k mit k = 1, ..., n und zum Beispiel über einen entsprechend implementierten Algorithmus die jeweiligen Leistungswerte und teilt diese der Leistungselektronik, zum Beispiel repräsentiert durch die Gleichspannungswandler 60, mit.

Folgende Aspekte sind unter anderem Gegenstand von Ausführungsformen der vorliegenden Erfindung, nämlich

(i) ein Verfahren zur Leistungsaufteilung im Allgemeinen und insbesondere in stationären Batteriespeichersystemen und zum Beispiel auf Basis von Parametern hinterlegter Kennfelder oder eines hinterlegten Batteriemodells,

(ii) ein Verfahren zur Leistungsaufteilung, das eine Leistungsprognose und/oder eine Energieprognose eines Parameterschätzers als Eingangswert oder Input zur Berechnung von Aufteilungsfaktoren nutzt,

(iii) ein Verfahren zur Leistungsaufteilung, das durch Freiheitsgrade von zwei unterschiedlichen Prognosezeiträumen eine Leistungsaufteilung beeinflussen kann, und/oder

(iv) ein Verfahren zur Leistungsaufteilung, das im Falle von Ausfällen einzelner Speicher dynamisch Aufteilungsfaktoren im Rahmen der Leistungsfähigkeit der restlichen Speicher anpasst.

Folgende Vorteile stellen sich erfindungsgemäß ein:
Im Gegensatz zu vorhandenen Verfahren zur Leistungsaufteilung, werden erfindungsgemäß - insbesondere alle - wichtigen Zielgrößen und batteriespezifischen Eigenschaften - insbesondere gleichzeitig - berücksichtigt.

Einige Vorteile der vorliegenden Erfindung beruhen also auf der Berücksichtigung dieser Eigenschaften wie Leistungsfähigkeit, Ladezustand, Temperatur, Energielimit etc. und finden sich in den folgenden drei Zielgrößen

- der Erfüllung von Leistungsanforderungen,

- dem Erreichen einer hohen Effizienz und

- dem Erreichen eines hohen Grads an Wirtschaftlichkeit

Dazu sind unter anderem auch die folgenden Aspekte wesentlich:

Erfüllung von Leistungsanforderungen: Während einer Leistungsreduktion eines Speichers wird das Leistungsdefizit von den weiteren teilnehmenden Speichern dynamisch über die prognostizierte Leistungsfähigkeit ausgeglichen und somit die Gesamtleistung weiterhin erfüllt. Dadurch kann das Gesamtsystem in größeren Betriebsbereichen betrieben werden, ohne die gestellten Anforderungen zu verletzen.

Effizienz: Die Speicher werden gemäß ihren individuellen Eigenschaften belastet und können somit effizienter betrieben werden. Beispielsweise wird bei zu niedrigen Temperaturen die Leistungsfähigkeit begrenzt.

Wirtschaftlichkeit: Durch die Verbesserung der Erfüllung von Leistungsanforderungen sowie durch die höhere Effizienz, verbessert diese Erfindung den ökonomischen Ertrag, der sich mit Energiespeicheranlagen erzielen lässt. Weiterhin muss beispielsweise zur Berechnung der Aufteilungsfaktoren kein rechenintensives Optimierungsproblem in Echtzeit gelöst werden. Dadurch kann auf einen kostentreibenden Controller verzichtet werden.

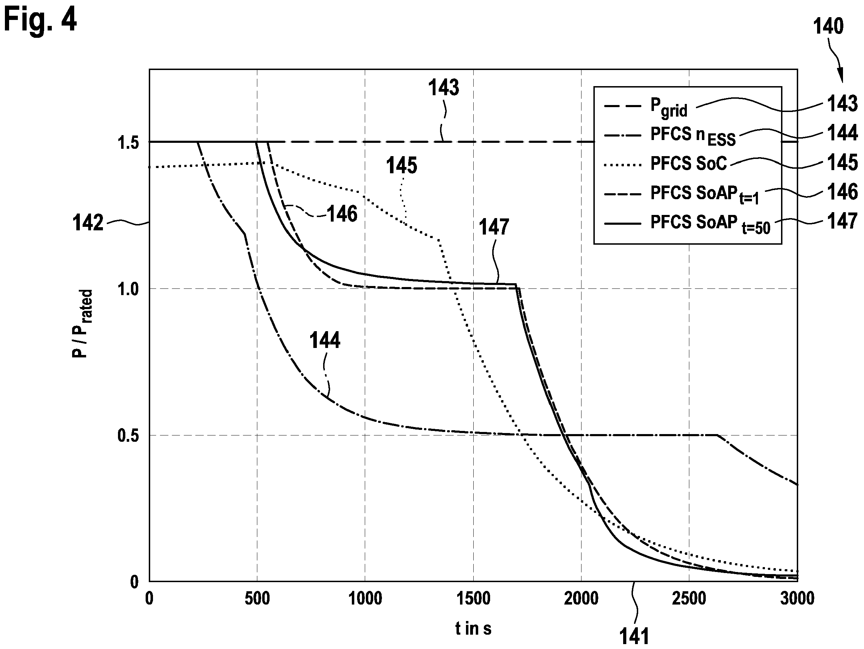

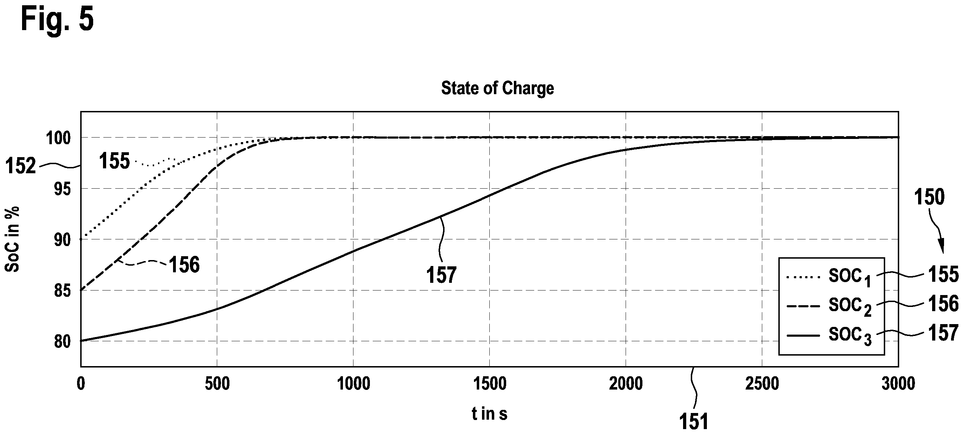

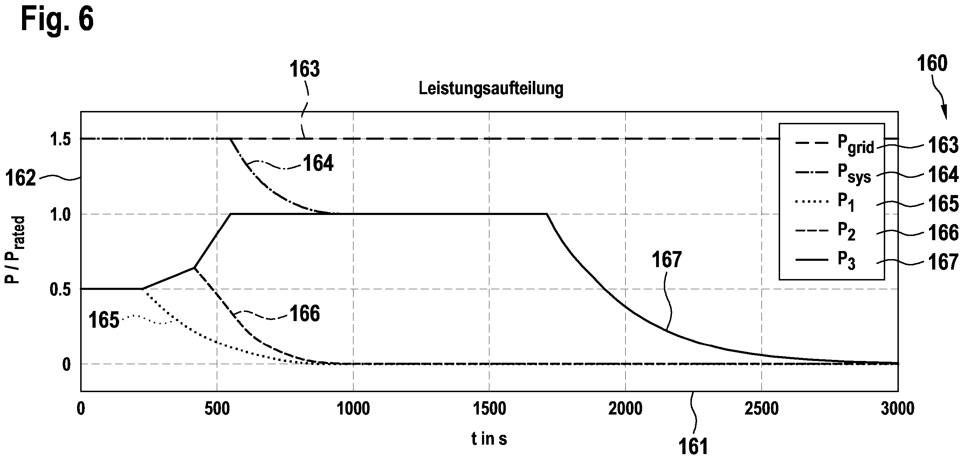

In diesem Zusammenhang beschreiben die Figuren 4 bis 6 anhand von Graphen 140, 150 und 160 Zusammenhänge im Hinblick auf eine Leistungserfüllung bei einer Ausführungsform des erfindungsgemäßen Verfahrens. Auf den Abszissen 141, 151, 161 ist jeweils die Zeit, auf den Ordinaten 142, 152 und 162 in den Graphen 140 und 160 der Figuren 4 und 6 der relative Leistungsanteil und im Graphen 150 der Figur 5 der Ladungszustand SoC der jeweiligen Energiespeicher 10-k; k = 1, ..., n der Energiespeicheranordnung 10 aufgetragen.
Die jeweiligen Spuren 143 bis 147, 155 bis 157, 163 bis 162, sind in den jeweiligen Legenden zu den Graphen 140, 51 und 160 erläutert.
In den Graphen 140, 150, 160 werden insbesondere Vorteile der vorliegenden Erfindung in Bezug auf die Erfüllung von Leistungsanforderungen dargestellt.
Dabei wurden insbesondere die folgenden Testbedingungen herangezogen:

- eine kontinuierliche Ladung der elektrischen Energiespeicher 10-k; k = 1, ..., n mit 1,5-facher Nennleistung,

- eine Simulationszeitspanne $t_{sim}$ = 3000 s,

- ein heterogenes Energiespeichersystem 10 mit den normierten Kapazitäten $K_1$ = 0,5, $K_2$ = 0,5, $K_3$ = 2,

- Ladezustände zu Beginn: $SoC_1$ = 90 %, $SoC_2$ = 85 %, $SoC_3$ = 80 %

- verschiedene Verfahren/Algorithmen zur Bestimmung der Leistungsaufteilung (PFCS)

    o PFCS nESS: statische Aufteilung gemäß Anzahl der Batterien

    o PFCS SoC: dynamische Aufteilung gemäß Ladezustand

    o PFCS SoAPt=1: dynamische Aufteilung gemäß Erfindung ($t_{prog,p}$ = 1 s und $t_{prog,e}$ = 1 s)

    o PFCS SoAPt=50: dynamische Aufteilung gemäß Erfindung ($t_{prog,p}$ = 1 s und $t_{prog,e}$ = 50 s)

- Energieprognose gemäß der Darstellung der einfachen Variante.

Die Graphen 150 und 160 der Figuren 5 und 6 zeigen das detaillierte Simulationsergebnis anhand des erfindungsgemäßen Verfahrens (PFCS SoAPt=1).
Der Graph 140 der Figur 4 zeigt, dass durch das erfindungsgemäße Verfahren und dessen Implementation als Algorithmus die Erfüllung von Leistungsanforderungen länger eingehalten werden kann. Durch die Wahl der Zeitkonstanten besteht zusätzlich die Möglichkeit, je nach Anwendungsfall den Grad der Erfüllung zu variieren. In diesem Beispiel führt eine höhere Zeitkonstante zu einer geringeren Erfüllung der Leistungsanforderungen.
Gemäß einer anderen Betrachtungsweise kann die vorliegende Erfindung zusätzlich oder alternativ auch als ein Verfahren zur Aufteilung von Leistung und/oder von Energie über verschiedene Energiespeicher eines Energiespeichersystems während des Auflade- und/oder Entladevorgangs aufgefasst werden.
Mittels Ausführungsformen des erfindungsgemäßen Verfahrens erfolgt in einem ersten Schritt für jeden Energiespeicher in einem Energiespeichersystem eine Abschätzung der tatsächlich zur Verfügung stehenden Energie und/oder Leistung und des maximal erreichbaren Ladezustands.

Diese Abschätzung beruht insbesondere auf einer im Rahmen der vorliegenden Erfindung entwickelten integralen Betrachtungsweise und/oder Berechnung, mittels welcher die Energie und/oder die Leistung in Abhängigkeit von mehreren Parametern, wie zum Beispiel einem aktuellen Energiespeicherladezustand und/oder dem Alterungsgrad des Energiespeichers, berechnet wird.

In einem zweiten Schritt kann dann eine auf den einzelnen Energiespeicher bezogene optimierte Aufteilung der dem Energiespeichersystem insgesamt zur Ladung und/oder Entladung zur Verfügung stehenden maximalen Leistung und/oder Energie erfolgen.

Die vorliegende Erfindung kann zum Beispiel auf dem Gebiet der stationären Energiespeicherung Anwendung finden. Stationäre Energiespeichersysteme können zum Beispiel ein grundsätzlicher Bestandteil von lokalen Stromnetzen und/oder Microgrids sein.

In diesem Zusammenhang kann die vorliegende Erfindung insbesondere aufgefasst werden als ein Verfahren zur Aufteilung des Leistungsflusses in einem Microgrid mit verteilten Energiespeichern und mit Netzanschluss.

Dabei können einzeln oder in beliebiger Kombination die folgenden Verfahrensschritte bei Ausführungsformen der vorliegenden Erfindung maßgeblich sein:

(i) Bereitstellen eines Microgrids, welches ausgebildet ist mit n = 1, ..., N gekoppelten Energiespeichern, die jeweils über ein zugeordnetes Energiemanagementsystem überwacht sind oder werden, mit einem DC-Zwischenkreis, mit einem oder mit mehreren Wandlern und mit einer Steuervorrichtung, wobei jeder Energiespeicher über je einen DC/DC-Wandler mit dem DC-Zwischenkreis und der DC-Zwischenkreis über einen DC/AC Wandler mit dem Netzanschluss verbunden sind und die Steuervorrichtung mit den Energiemanagementsystemen und den Wandlern verbunden ist,

(ii) Festlegen eines Prognosezeitraums oder einer Prognosezeitspanne $t$, wobei das Verfahren für große Zeitspannen $t$ verstärkt auf eine schnelle Ladezustandsangleichung der elektrischen Energiespeicher 10-k und für kleine Zeitspannen $t$ verstärkt auf eine maximale Leistungsperformance der Energiespeicher 10-k ausgelegt ist oder wird,

(iii) Berechnen einer prognostizierten, maximalen Leistung $P_{prog,max,k}$ über den Prognosezeitraum $t$ für jeden Energiespeicher 10-k aus dem Energiespeicherladezustand ($SoC$ : state-of-charge), wobei der Wert $P_{prog,max,k}$ auf eine maximale Leistung limitiert oder beschränkt wird, die das Energiemanagementsystem, das dem jeweiligen k-ten Energiespeicher 10-k zugeordnet ist, unter Berücksichtigung der maximalen Strom-, Spannungs- und SoC-Spezifikationsgrenzen (oder eines Batteriemodells) für den Prognosezeitraum $t$ zurückliefert,

(iv) Bestimmen der Aufteilung des Leistungsflusses für eine bereitzustellende Leistung durch die Energiespeicher 10-k in Bezug auf eine vorgegebene Sollleistung $P_{soll}$ oder $P^*$, wobei die bereitzustellende Leistung auf die prognostizierte, maximale Summenleistung $P_{prog,max,sum} = \Sigma(P_{prog,max,k})$ der Energiespeicher 10-k begrenzt wird, also insbesondere auf eine (prognostizierte) momentan verfügbaren elektrischen Gesamtladeleistung $P_{ch,gesamt}$ und/oder Gesamtentladeleistung $P_{dch,gesamt}$ sämtlicher elektrischer Energiespeicher 10-k; k = 1, ..., n) der Energiespeicheranordnung (10) in Summe, und jeder Energiespeicher 10-k einen Leistungsanteil $P_k$ bereitstellt, der dem Verhältnis seiner prognostizierten, maximalen Leistung $P_{prog,max,k}$ zur prognostizierten, maximalen Summenleistung $P_{prog,max,sum}$ entspricht, also z.B. $P_k = P_{soll} \cdot P_{prog,max,k} / P_{prog,max,sum}$ für k = 1, ..., n.

Neben der vorstehenden schriftlichen Beschreibung der Erfindung wird zu deren ergänzender Offenbarung hiermit explizit auf die zeichnerische Darstellung der Erfindung in den Figuren 1 bis 6 Bezug genommen.

**Bezugszeichenliste**

| | |
|---|---|
| 1 | System, Netz, Stromnetz, Microgrid |
| 2 | Hauptstrang, Hauptleitung |
| 10 | (elektrische) Energiespeicheranordnung |
| 10-k | (elektrischer) Energiespeicher mit k = 1, ..., n und n, k als natürliche Zahlen |
| 11 | Leitung |
| 20 | Leistungssenken, Verbraucher, Last |
| 21 | Leitung |
| 30 | Leistungsquelle, Erzeuger, Generator |

31 Leitung
40 Hauptnetz, Hauptnetzanschluss
41 Leitung
50 Steuereinheit
51 Steuer- und/oder Erfassungsleitung
52 Steuer- und/oder Erfassungsleitung
55 Mikrocontroller
60 Gleichspannungswandler, DC-DC-Wandler
61 Leitung
70 Gleichrichter, AC-DC-Wandler
71 Leitung
100 Graph
101 Abszisse
102 Ordinate
103 Spur
104 Spur
105 Spur

140 Graph
141 Abszisse
142 Ordinate
143 Spur
144 Spur
145 Spur
146 Spur
147 Spur
150 Graph
151 Abszisse
152 Ordinate
155 Spur
156 Spur
157 Spur

160 Graph
161 Abszisse
162 Ordinate
163 Spur
164 Spur
165 Spur
166 Spur
167 Spur

**Patentansprüche**

1. Verfahren zum Bestimmen eines - insbesondere relativen - Leistungsanteils ($P_k$; k = 1, ..., n) eines elektrischen Energiespeichers (10-k; k = 1, ..., n) einer Energiespeicheranordnung (10) einer Mehrzahl elektrischer Energiespeicher (10-k; k = 1, ..., n) an einer extern angeforderten und/oder bereitgestellten elektrischen Leistung ($P_{soll}$), bei welchem:

(i) für den und insbesondere für jeden elektrischen Energiespeicher (10-k; k = 1, ..., n) der Energiespeicheranordnung (10) eine momentan verfügbare maximale elektrische Ladeleistung ($P_{ch,k}$, k = 1, ..., n), eine momentan verfügbare maximale elektrische Entladeleistung ($P_{dch,k}$, k = 1, ..., n) und/oder jeweils dafür charakteristische Werte ermittelt wird bzw. werden, insbesondere durch Prognose,

(ii) die ermittelte momentan verfügbare maximale elektrische Ladeleistung ($P_{ch,k}$, k = 1, ..., n) und/oder Entladeleistung ($P_{dch,k}$, k = 1, ..., n) eines elektrischen Energiespeichers (10-k; k = 1, ..., n) ins Verhältnis gesetzt wird zur momentan verfügbaren elektrischen Gesamtladeleistung ($P_{ch,gesamt}$) und/oder Gesamtentladeleistung ($P_{dch,gesamt}$) sämtlicher elektrischer Energiespeicher (10-k; k = 1, ..., n) der Energiespeicheranordnung (10) in Summe und

(iii) ein jeweils ermitteltes Verhältnis als - insbesondere relativer - elektrischer Leistungsanteil ($P_k$; k = 1, ..., n) des jeweiligen elektrischen Energiespeichers (10-k; k = 1, ..., n) und insbesondere als Steuergröße für eine Leistungsaufteilung und/oder für eine Aufteilung eines Leistungsflusses bereitgestellt und/oder ausgegeben wird bzw. werden.

2. Verfahren nach Anspruch 1, bei welchem:

- die momentan verfügbare maximale elektrische Ladeleistung ($P_{ch,k}$) und/oder die momentan verfügbare maximale elektrische Entladeleistung ($P_{dch,k}$) eines elektrischen Energiespeichers (10-k; k = 1, ..., n) aus einem und/oder mehreren Prognoseverfahren ermittelt wird oder werden,
- bei der Verwendung mehrerer Prognoseverfahren der Wert einer momentan verfügbaren maximalen elektrischen Ladeleistung ($P_{ch,k}$) und/oder der Wert einer momentan verfügbaren maximalen elektrischen Entladeleistung ($P_{dch,k}$) eines elektrischen Energiespeichers (10-k; k = 1, ..., n) über eine Minimumsbildung von Werten aus der Mehrzahl von Leistungsprognosen ermittelt wird bzw. werden, und/oder
- ein Prognoseverfahren unter der Berücksichtigung von Spannungsgrenzen, ein Prognoseverfahren unter der Berücksichtigung von Stromgrenzen, ein Prognoseverfahren unter der Berücksichtigung von Ladungsmengengrenzen und/oder ein Prognoseverfahren unter Berücksichtigung von Energiegrenzen verwendet wird oder werden.

3. Verfahren nach einem der vorangehenden Ansprüche, bei welchem:

(i) die momentan verfügbare maximale elektrische Ladeleistung ($P_{ch}$) eines elektrischen Energiespeichers (10-k; k = 1, ..., n) aus einer momentan verfügbaren elektrischen Ladeenergie ($E_{ch}$) des elektrischen Energiespeichers (10-k; k = 1, ..., n) ermittelt wird, und/oder
(ii) die momentan verfügbare maximale elektrische Entladeleistung ($P_{dch}$) eines elektrischen Energiespeichers (10-k; k = 1, ..., n) aus einer momentan verfügbaren elektrischen Entladeenergie ($E_{dch}$) des elektrischen Energiespeichers (10-k; k = 1, ..., n) ermittelt wird,

insbesondere

(iii) jeweils im Ruhezustand und/oder stromlosen Zustand des elektrischen Energiespeichers (10-k; k = 1, ..., n) und/oder
(iv) jeweils als eine oder auf der Grundlage einer zeitabhängigenladungsmengengrenzenlimitierten und/oder energiegrenzenlimitierten mittleren elektrischen Ladeleistung $P_{prog,e,ch}$ bzw. Entladeleistung $P_{prog,e,dch}$ bzw. über eine vorbestimmte Prognosezeitspanne $t_{prog,e}$ und/oder
(v) gemäß der nachfolgenden Vorschrift (1)

$$P_{prog,e,ch}(t) = \frac{E_{prog,ch}(t)}{t_{prog,e}} \qquad (1)$$

bzw. gemäß der nachfolgenden Vorschrift (2)

$$P_{prog,e,dch}(t) = \frac{E_{prog,dch}(t)}{t_{prog,e}} \qquad (2)$$

wobei $E_{prog,ch}$ und $E_{prog,dch}$ eine jeweilige momentan vorliegende elektrische Ladeenergie bzw. Entladeenergie eines jeweiligen Energiespeichers (10-k; k = 1, ..., n) bezeichnen, und/oder
(vi) mit einer Prognosezeitspanne ($t_{prog,e}$), die (a) als freier Parameter optimiert wird, (b) zielgrößenabhängig ist, (c) in Bezug auf Effizienz, Bereitschaft und/oder Lastszenario angepasst ist oder wird.

4. Verfahren nach einem der vorangehenden Ansprüche, bei welchem:

- die momentan verfügbare elektrische Ladeenergie $E_{ch}$ eines elektrischen Energiespeichers (10-1, ..., 10-n) gemäß der nachfolgenden Vorschrift (3)

$$E_{ch}(t) = K(T,SoH) \cdot \int_{SoC(t)}^{SoC_{max}} OCV(SoC,T,SoH)\, dSoC \qquad (3)$$

ermittelt wird und/oder
- die momentan verfügbare elektrische Entladeenergie $E_{dch}$ eines elektrischen Energiespeichers (10-1, ..., 10-n) gemäß der nachfolgenden Vorschrift (4)

$$E_{dch}(t) = K(T,SoH) \cdot \int_{SoC_{min}}^{SoC(t)} OCV(SoC,T,SoH)\, dSoC \qquad (4)$$

ermittelt wird,
- wobei $t$ die Zeit, $K$ eine Gesamtkapazität eines jeweiligen Energiespeichers (10-k; k = 1, ..., n) in Abhängigkeit von Temperatur $T$ und Alterungsgrad $SoH$, $OCV$ die Ruhespannung des jeweiligen Energiespeichers (10-k; k = 1, ..., n) in Abhängigkeit vom Ladezustand SoC, Temperatur $T$ und Alterungsgrad $SoH$, $SoC_{min}$ und $SoC_{max}$ Minimum bzw. Maximum des Ladezustands SoC des Energiespeichers (10-k; k = 1, ..., n) bezeichnen.

5. Verfahren nach einem der vorangehenden Ansprüche, bei welchem für einen jeweiligen Energiespeicher (10-k; k = 1, ..., n) die momentan verfügbare elektrische Ladeenergie ($E_{ch}$) und/oder die momentan verfügbare elektrische Entladeenergie ($E_{dch}$)

   - mittels einer Prognose,
   - auf der Grundlage eines Kennfeldes und/oder
   - auf der Grundlage eines Modells des Energiespeichers (10-k; k = 1, ..., n) und insbesondere eines Batteriemodells und zusätzlich erfasster Daten, welche für einen aktuellen Zustand des Energiespeichers (10-k; k = 1, ..., n) charakteristisch sind,

   ermittelt wird bzw. werden, insbesondere im Zusammenhang mit einer Temperaturabhängigkeit und/oder einer Zeitabhängigkeit der jeweiligen Gesamtkapazität ($K$), des Ladezustands (SoC), des Alterungszustands ($SoH$) und/oder der Ruhespannung (OCV) eines jeweiligen Energiespeichers (10-k; k = 1, ..., n).

6. Verfahren nach einem der vorangehenden Ansprüche, bei welchem:

   - die momentan verfügbare maximale elektrische Ladeleistung ($P_{ch}$) eines elektrischen Energiespeichers (10-k; k = 1, ..., n) als kleinste elektrische Ladeleistung aus einer stromgrenzenlimitierten mittleren elektrischen Ladeleistung $P_{prog,i,ch}$, einer spannungsgrenzenlimitierten mittleren elektrischen Ladeleistung $P_{prog,u,ch}$ und/oder einer oder der ladungsmengengrenzenlimitierten und/oder energiegrenzenlimitierten mittleren elektrischen Ladeleistung $P_{prog,e,ch}$ ermittelt wird, insbesondere gemäß der nachfolgenden Vorschrift (5)

$$\left| P_{prog,ch} \right| = min \left( \left| P_{prog,i,ch} \right|, \left| P_{prog,u,ch} \right|, \left| P_{prog,e,ch} \right| \right) \qquad (5)$$

   und/oder
   - die momentan verfügbare maximale elektrische Entladeleistung ($P_{dch}$) eines elektrischen Energiespeichers (10-k; k = 1, ..., n) als kleinste elektrische Entladeleistung aus einer stromgrenzenlimitierten mittleren elektrischen Entladeleistung $P_{prog,i,dch}$, einer spannungsgrenzenlimitierten mittleren elektrischen Entladeleistung $P_{prog,u,dch}$ und/oder einer oder der ladungsmengengrenzenlimitierten und/oder energiegrenzenlimitierten mittleren elektrischen Ladeleistung $P_{prog,e,dch}$ ermittelt, wird insbesondere gemäß der nachfolgenden Vorschrift (6)

$$\left| P_{prog,dch} \right| = min \left( \left| P_{prog,i,dch} \right|, \left| P_{prog,u,dch} \right|, \left| P_{prog,e,dch} \right| \right) \qquad (6)$$

7. Verfahren nach einem der vorangehenden Ansprüche, bei welchem die momentan verfügbare elektrische Ladeenergie $E_{ch}$ und/oder die momentan verfügbare elektrische Entladeenergie $E_{dch}$ außerhalb eines Ruhezustands und/oder eines stromlosen Zustands ermittelt und/oder dynamisch korrigiert werden, wobei insbesondere

- die dynamisch korrigierte momentan verfügbare elektrische Ladeenergie $E_{dyn,ch}$ eines elektrischen Energiespeichers (10-k; k = 1, ..., n) gemäß der nachfolgenden Vorschrift (7)

$$E_{dyn,ch}(t) = K(T,SoH) \cdot \left( \int_{SoC(t)}^{SoC_{max}} OCV(SoC,T,SoH) \, dSoC + \int_{SoC(t)}^{SoC_{max}} \Delta U_{dyn}(SoC,T,SoH) \, dSoC \right)$$

$$(7)$$

oder gemäß der weiter angepassten Vorschrift (7a)

$$E_{dyn,ch}(t) = K(T,SoH) \cdot \left( \int_{SoC(t)}^{SoC_{max,dyn}} OCV(SoC,T,SoH) \, dSoC + \int_{SoC(t)}^{SoC_{max,dyn}} \Delta U_{dyn}(SoC,T,SoH) \, dSoC \right)$$

$$(7a)$$

ermittelt wird und/oder
- die dynamisch korrigierte momentan verfügbare elektrische Entladeenergie $E_{dyn,dch}$ eines elektrischen Energiespeichers (10-k; k = 1, ..., n) gemäß der nachfolgenden Vorschrift (8)

$$E_{dyn,dch}(t) = K(T,SoH) \cdot \left( \int_{SoC_{min}}^{SoC(t)} OCV(SoC,T,SoH) \, dSoC + \int_{SoC_{min}}^{SoC(t)} \Delta U_{dyn}(SoC,T,SoH) \, dSoC \right)$$

$$(8)$$

oder gemäß der weiter angepassten Vorschrift (8a)

$$E_{dyn,dch}(t) = K(T,SoH) \cdot \left( \int_{SoC_{min,dyn}}^{SoC(t)} OCV(SoC,T,SoH) \, dSoC + \int_{SoC_{min,dyn}}^{SoC(t)} \Delta U_{dyn}(SoC,T,SoH) \, dSoC \right)$$

$$(8a)$$

ermittelt wird und/oder
- wobei t die Zeit, $K$ eine Gesamtkapazität eines jeweiligen Energiespeichers (10-k; k = 1, ..., n) in Abhängigkeit von Temperatur $T$ und Alterungsgrad $SoH$, $OCV$ die Ruhespannung des jeweiligen Energiespeichers (10-k; k = 1, ..., n) in Abhängigkeit vom Ladezustand SoC, Temperatur $T$ und Alterungsgrad $SoH$, $SoC_{min}$ und $SoC_{max}$ Minimum bzw. Maximum des Ladezustands $SoC$, $SoC_{min,dyn}$ und $SoC_{max,dyn}$ das dynamisch angepasste Minimum bzw. das dynamisch angepasste Maximum des Ladezustands SoC des Energiespeichers (10-k; k = 1, ..., n) bezeichnen.

8. Verfahren nach einem der vorangehenden Ansprüche, bei welchem für einen jeweiligen elektrischen Energiespeicher (10-k; k = 1, ..., n) der Mehrzahl elektrischer Energiespeicher (10-k; k = 1, ..., n) der Energiespeicheranordnung (10) bei einer extern angeforderten und/oder bereitgestellten elektrischen Sollleistung ($P_{soll}$) eine jeweils anteilige Teilleistung ($P_k$; k = 1, ..., n)

(i) proportional zum Anteil einer prognostizierten Teilleistung ($P_{prog,k}$) des gegebenen elektrischen Energiespeichers (10-k) an der gesamten prognostizierten Leistung für alle elektrischen Energiespeicher (10-k; k = 1, ...,

n) der Energiespeicheranordnung (10),
(ii) proportional zum Minimum über der gesamten prognostizierten Leistung und der Sollleistung ($P_{\text{soll}}$) und/oder
(iii) bestimmbar gemäß der nachfolgenden Vorschrift (9)

$$P_k = min\left(\Sigma_{n=1}^{n_{ESS}} |P_{prog,n}|, |P_{soll}|\right) \cdot \frac{|P_{prog,k}|}{\Sigma_{n=1}^{n_{ESS}} |P_{prog,n}|} \qquad (9)$$

**9.** Betriebsverfahren für eine elektrische Energiespeicheranordnung (10) mit einer Mehrzahl elektrischer Energiespeicher (10-k; k = 1, ..., n),

- bei welchem eine extern angeforderte und/oder bereitgestellte elektrische Leistung ($P_{\text{soll}}$) unter elektrischen Energiespeichern (10-k; k = 1, ..., n) der Mehrzahl elektrischer Energiespeicher (10-k; k = 1, ..., n) der Energiespeicheranordnung (10) auf der Grundlage eines Verfahrens nach einem der Ansprüche 1 bis 8 aufgeteilt wird und
- welches insbesondere als Betriebsverfahren für ein Stromnetz (1) oder als Teil davon ausgebildet ist.

**10.** Steuereinheit (50) für eine Energiespeicheranordnung (10) und/oder für ein Stromnetz (1),

- welche eingerichtet ist, ein Verfahren zum Bestimmen eines relativen Leistungsanteils eines elektrischen Energiespeichers (10-k; k = 1, ..., n) einer Energiespeicheranordnung (10) einer Mehrzahl elektrischer (10-k; k = 1, ..., n) nach einem der Ansprüche 1 bis 8 und/oder ein Betriebsverfahren nach Anspruch 9 zu initiieren, auszuführen, zu steuern und/oder mit einem oder in einem solchen Verfahren verwendet zu werden und
- welche insbesondere als Teil einer Energiespeicheranordnung (10) und/oder eines Stromnetzes (1) ausgebildet ist.

**11.** Energiespeicheranordnung (10) mit einer Mehrzahl elektrischer Energiespeicher (10-k; k = 1, ..., n),

- welche eingerichtet ist, ein Verfahren zum Bestimmen eines relativen Leistungsanteils eines elektrischen Energiespeichers (10-k; k = 1, ..., n) nach einem der Ansprüche 1 bis 7 und/oder ein Betriebsverfahren nach Anspruch 8 zu initiieren, auszuführen, zu steuern und/oder mit einem oder in einem solchen Verfahren verwendet zu werden,
- welche dazu eine Steuereinheit (50) nach Anspruch 10 oder eine Wirkverbindung zu einer derartigen Steuereinheit (50) aufweist und/oder
- welche als Teil eines Stromnetzes (1) ausgebildet ist.

**12.** Stromnetz (1), insbesondere lokales Stromnetz oder Microgrid,

- welches eingerichtet ist, ein Verfahren zum Bestimmen eines relativen Leistungsanteils eines elektrischen Energiespeichers (10-k; k = 1, ..., n) nach einem der Ansprüche 1 bis 8 und/oder ein Betriebsverfahren nach Anspruch 9 zu initiieren, auszuführen, zu steuern und/oder mit einem oder in einem solchen Verfahren verwendet zu werden und
- welches dazu eine Energiespeicheranordnung (10) nach Anspruch 11, eine Steuereinheit (50) nach Anspruch 10 und/oder eine Wirkverbindung zu einer derartigen Energiespeicheranordnung (10) und/oder einer Steuereinheit (50) aufweist.

# Fig. 1

EP 3 787 141 A1

Fig. 2A

**Fig. 2B**

**Fig. 3**

EP 3 787 141 A1

Fig. 4

EP 3 787 141 A1

Fig. 5

**Fig. 6**

Leistungsaufteilung

160

161

162

163 — $P_{grid}$
164 — $P_{sys}$
165 — $P_1$
166 — $P_2$
167 — $P_3$

$P / P_{rated}$

t in s

Europäisches
Patentamt

European
Patent Office

Office européen
des brevets

**EUROPÄISCHER RECHERCHENBERICHT**

Nummer der Anmeldung

EP 20 18 1618

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | WO 2019/049571 A1 (PANASONIC IP MAN CO LTD [JP]) 14. März 2019 (2019-03-14) * Absätze [0008], [0020] - [0039], [0051] - [0057], [0077] - [0079]; Abbildungen 1-7 * ----- | 1-12 | INV. H02J3/00 H02J3/32 H02J7/00 B60L53/63 B60L58/12 |
| A | US 2017/285111 A1 (FIFE JOHN MICHAEL [US]) 5. Oktober 2017 (2017-10-05) * Absätze [0004], [0005], [0010], [0011], [0036], [0054] - [0085], [0144], [0288] - [0290]; Abbildungen 1-25 * ----- | 1-12 | B60L58/16 B60L58/18 B60L58/24 B60L55/00 G01R31/387 G01R31/392 |

RECHERCHIERTE
SACHGEBIETE (IPC)

H02J
B60L
G01R

Der vorliegende Recherchenbericht wurde für alle Patentansprüche erstellt

| Recherchenort | Abschlußdatum der Recherche | Prüfer |
|---|---|---|
| Den Haag | 8. Dezember 2020 | Schury, Dominik |

KATEGORIE DER GENANNTEN DOKUMENTE

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus anderen Gründen angeführtes Dokument

........................................................................

& : Mitglied der gleichen Patentfamilie, übereinstimmendes
Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**

EP 20 18 1618

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

08-12-2020

| Im Recherchenbericht angeführtes Patentdokument | Datum der Veröffentlichung | Mitglied(er) der Patentfamilie | Datum der Veröffentlichung |
|---|---|---|---|
| WO 2019049571 A1 | 14-03-2019 | CN 110892606 A | 17-03-2020 |
| | | JP WO2019049571 A1 | 20-08-2020 |
| | | US 2020176829 A1 | 04-06-2020 |
| | | WO 2019049571 A1 | 14-03-2019 |
| US 2017285111 A1 | 05-10-2017 | AU 2017244131 A1 | 27-09-2018 |
| | | CA 3019641 A1 | 05-10-2017 |
| | | KR 20180122472 A | 12-11-2018 |
| | | US 2017285111 A1 | 05-10-2017 |
| | | US 2017285587 A1 | 05-10-2017 |
| | | US 2017285678 A1 | 05-10-2017 |
| | | US 2017286882 A1 | 05-10-2017 |
| | | US 2017288399 A1 | 05-10-2017 |
| | | US 2017288455 A1 | 05-10-2017 |
| | | US 2019042992 A1 | 07-02-2019 |
| | | US 2019340555 A1 | 07-11-2019 |
| | | US 2020005208 A1 | 02-01-2020 |
| | | WO 2017173041 A1 | 05-10-2017 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102009049589 A1